# NEW EUROPEAN PATENT SPECIFICATION

(11) **EP 1 729 327 B2**
(45) Date of publication and mention of the opposition decision: **10.08.2022**
(45) Mention of the grant of the patent: 22.11.2017
(21) Application number: 06016911.7
(22) Date of filing: 11.05.2000
(51) Int. Cl.: H01L 21/00, C09K 11/06, H05B 33/14, H01L 51/50, H01L 51/30

(54) **Use of a phosphorescent iridium compound as emissive molecule in an organic light emitting device**
Verwendung einer phosphoreszierenden Iridiumverbindung als Emissionsmolekül in einer organischen lichtemittierenden Vorrichtung
Utilisation d'un composé d'iridium phosphorescent comme molécule émissive dans un dispositif électroluminescent organique

(30) Priority: 13.05.1999 US 311126
(43) Date of publication of application: 06.12.2006
(62) Divisional of application: 00932308.0
(73) Proprietor: THE TRUSTEES OF PRINCETON UNIVERSITY, Princeton, NJ 08544-0636 (US); THE UNIVERSITY OF SOUTHERN CALIFORNIA, Los Angeles, California 90089 (US)
(72) Inventor: Baldo, Marc A., Princeton, NJ 08544 (US); Burrows, Paul E., Kennewick, WA 99338 (US); Forrest, Stephen R., Princeton, NJ 08540 (US); Thompson, Mark E., Anaheim, CA 92807 (US); Lamansky, Sergey, Apple Valley, MN 55124 (US); Djurovich, Peter, Long Beach, California 90802 (US)
(74) Representative: Maiwald Patent- und Rechtsanwaltsgesellschaft mbH

(56) References cited:
- WO-A1-01/41512
- JP-A- H07 263 145
- BALDO M A ET AL: "Very high-efficiency green organic light-emitting devices based on electrophosphorescence" APPLIED PHYSICS LETTERS, AMERICAN INSTITUTE OF PHYSICS. NEW YORK, US, vol. 75, no. 1, 5 July 1999 (1999-07-05), pages 4-6, XP002199390 ISSN: 0003-6951
- BALDO M A ET AL: "HIGHLY EFFICIENT PHOSPHORESCENT EMISSION FROM ORGANIC ELECTROLUMINESCENT DEVICES" NATURE, MACMILLAN JOURNALS LTD. LONDON, GB, vol. 395, no. 6698, 10 September 1998 (1998-09-10), pages 151-154, XP001002103 ISSN: 0028-0836
- O'BRIEN D F ET AL: "IMPROVED ENERGY TRANSFER IN ELECTROPHOSPHORESCENT DEVICES" APPLIED PHYSICS LETTERS, AMERICAN INSTITUTE OF PHYSICS. NEW YORK, US, vol. 74, no. 3, 18 January 1999 (1999-01-18), pages 442-444, XP000805586 ISSN: 0003-6951
- KING K A ET AL: "EXCITED-STATE PROPERTIES OF A TRIPLY ORTHO-METALATED IRIDIUM (III) COMPLEX" JOURNAL OF THE AMERICAN CHEMICAL SOCIETY, AMERICAN CHEMICAL SOCIETY, WASHINGTON, DC, US, vol. 107, no. 107, 1985, pages 1431-1432, XP001069823 ISSN: 0002-7863
- MARCO DI G ET AL: "LUMINESCENT MONONUCLEAR AND DINUCLEAR IRIDIUM(III) CYCLOMETALATED COMPLEXES IMMOBILIZED IN A POLYMERIC MATRIX AS SOLID-STATE OXYGEN SENSORS" ANALYTICAL CHEMISTRY, AMERICAN CHEMICAL SOCIETY. COLUMBUS, US, vol. 70, no. 23, 1 December 1998 (1998-12-01), pages 5019-5023, XP000799212 ISSN: 0003-2700
- CALOGERO G ET AL: "ABSORPTION SPECTRA; LUMINESCENCE PROPERTIES, AND ELECTROCHEMICAL BEHAVIOR OF CYCLOMETALATED IRIDIUM (III) AND RHODIUM (III) COMPLEXES WITH A BIS(PYRIDYL)TRIAZOLE LIGAND" INORGANIC CHEMISTRY, AMERICAN CHEMICAL SOCIETY, EASTON, US, vol. 34, no. 3, 1 February 1995 (1995-02-01), pages 541-545, XP002231208 ISSN: 0020-1669
- G. L. MIESSLER et al.: Inorganic Chemistry, 1998, pages 1-3 , 422- 424,
- M. A. BALDO et al.: Pure Appl. Chem., vol. 71, no. 11, 1999, pages 2095-2106,
- D. M. P. Mingos et al.: "Organometallic Complexes for Optoelectronic Applications" In: "Comprehensive Organometallic Chemistry III", 2007 pages 101-194,
- Untersuchungen am Komplex Ir-1,
- Investigation of some photophysical properties of Ir-1,
- T. SAJOTO et al.: Inorg. Chem., vol. 44, no. 22, 2005, pages 7992-8003, XP055456367,
- Englische Ubersetzung von D8 .,
- R. C. KWONG et al.: "Organic Light-emitting Devices Based on Phosphorescent Hosts and Dyes", Adv. Mater., vol. 12, no. 15, 2000, pages 1134-1138,
- Organische Elektrolumineszenzvorrichtungen mit Ir(ppy)3,
- Y. MA et al.: Synthetic Metals, vol. 94, 1998, pages 245-248,
- G. DI MARCO et al.: "A luminescent iridium(III) cyclometallated complex immobilized in a polymeric matrix as a solid-state oxygen sensor", Adv. Mater., vol. 8, no. 7, 1996, pages 576-580,
- A. J. LEES: Chem. Reviews, vol. 87, no. 4, 1987, pages 711-743,
- M. A. BALDO et al.: Nature, vol. 394, 1998, pages 151-154,
- G. COLOMBO et al.: "Competition between ligand centered and charge transfer lowest excited states in bis cyclometalated Rh3+ and Ir3+ complexes", Topics in Current Chemistry, vol. 171, 1994, pages 143-171,
- K. A. KING et al.: J. Am. Chem. Soc., vol. 107, 1985, pages 1431-1432,
- Declaration Hermann
- Curriculum vitae Hermann
- IUPAC Organometalic
- Declaration Weaver
- Curriculum vitae Weaver
- Declaration Thompson
- Curriculum vitae Thompson
- Improved energy transfer in electrophosphorescent devices, Appl Phys Lett. 74 (1999) 442, D F O?Brien
- Excerpt Dictionary

## Description

### I. FIELD OF INVENTION

The present invention is directed to the use of a phosphorescent organometallic cyclometallated iridium compound as defined in claim 1.

### II. BACKGROUND OF THE INVENTION

### II. A. General Background

Organic light emitting devices (OLEDs) are comprised of several organic layers in which one of the layers is comprised of an organic material that can be made to electroluminesce by applying a voltage across the device, C.W. Tang et al., Appl. Phys. Lett. 1987, 51, 913. Certain OLEDs have been shown to have sufficient brightness, range of color and operating lifetimes for use as a practical alternative technology to LCD-based full color flat-panel displays (S.R. Forrest, P.E. Burrows and M.E. Thompson, Laser Focus World, Feb. 1995). Since many of the thin organic films used in such devices are transparent in the visible spectral region, they allow for the realization of a completely new type of display pixel in which red (R), green (G), and blue (B) emitting OLEDs are placed in a vertically stacked geometry to provide a simple fabrication process, a small R-G-B pixel size, and a large fill factor, International Patent Application No. WO9619792.

A transparent OLED (TOLED), which represents a significant step toward realizing high resolution, independently addressable stacked R-G-B pixels, was reported in International Patent Application No. WO9733296 in which the TOLED had greater than 71% transparency when turned off and emitted light from both top and bottom device surfaces with high efficiency (approaching 1% quantum efficiency) when the device was turned on. The TOLED used transparent indium tin oxide (ITO) as the hole-injecting electrode and a Mg-Ag-ITO electrode layer for electron-injection. A device was disclosed in which the ITO side of the Mg-Ag-ITO layer was used as a hole-injecting contact for a second, different color-emitting OLED stacked on top of the TOLED. Each layer in the stacked OLED (SOLED) was independently addressable and emitted its own characteristic color. This colored emission could be transmitted through the adjacently stacked, transparent, independently addressable, organic layer or layers, the transparent contacts and the glass substrate, thus allowing the device to emit any color that could be produced by varying the relative output of the red and blue color-emitting layers. WO9619792 application disclosed an integrated SOLED for which both intensity and color could be independently varied and controlled with external power supplies in a color tunable display device. The WO9619792 application, thus, illustrates a principle for achieving integrated, full color pixels that provide high image resolution, which is made possible by the compact pixel size. Furthermore, relatively low cost fabrication techniques, as compared with prior art methods, may be utilized for making such devices.

### II.B. Background of emission

Devices whose structure is based upon the use of layers of organic optoelectronic materials generally rely on a common mechanism leading to optical emission. Typically, this mechanism is based upon the radiative recombination of a trapped charge. Specifically, OLEDs are comprised of at least two thin organic layers separating the anode and cathode of the device. The material of one of these layers is specifically chosen based on the material's ability to transport holes, a "hole transporting layer" (HTL), and the material of the other layer is specifically selected according to its ability to transport electrons, an "electron transporting layer" (ETL). With such a construction, the device can be viewed as a diode with a forward bias when the potential applied to the anode is higher than the potential applied to the cathode. Under these bias conditions, the anode injects holes (positive charge carriers) into the hole transporting layer, while the cathode injects electrons into the electron transporting layer. The portion of the luminescent medium adjacent to the anode thus forms a hole injecting and transporting zone while the portion of the luminescent medium adjacent to the cathode forms an electron injecting and transporting zone. The injected holes and electrons each migrate toward the oppositely charged electrode. When an electron and hole localize on the same molecule, a Frenkel exciton is formed. Recombination of this short-lived state may be visualized as an electron dropping from its conduction potential to a valence band, with relaxation occurring, under certain conditions, preferentially via a photoemissive mechanism. Under this view of the mechanism of operation of typical thin-layer organic devices, the electroluminescent layer comprises a luminescence zone receiving mobile charge carriers (electrons and holes) from each electrode.

Light emission from OLEDs is typically via fluorescence or phosphorescence. There are issues with the use of phosphorescence. It has been noted that phosphorescent efficiency decreases rapidly at high current densities. It may be that long phosphorescent lifetimes cause saturation of emissive sites, and triplet-triplet annihilation may produce efficiency losses. Another difference between fluorescence and phosphorescence is that energy transfer of triplets from a conductive host to a luminescent guest molecule is typically slower than that of singlets; the long range dipole-dipole coupling (Förster transfer) which dominates energy transfer of singlets is (theoretically) forbidden for triplets by the principle of spin symmetry conservation. Thus, for triplets, energy transfer typically occurs by diffusion of excitons to neighboring molecules (Dexter transfer); significant overlap of donor and acceptor excitonic wavefunctions is critical to energy transfer. Another issue is that triplet diffusion lengths are typically long (e.g., >1400Å) compared with typical singlet diffusion lengths of about 200Å. Thus, if phosphorescent devices are to achieve their potential, device structures need to be optimized for triplet properties. In this invention, we exploit the property of long triplet diffusion lengths to improve external quantum efficiency.

Successful utilization of phosphorescence holds enormous promise for organic electroluminescent devices. For example, an advantage of phosphorescence is that all excitons (formed by the recombination of holes and electrons in an EL), which are (in part) triplet-based in phosphorescent devices, may participate in energy transfer and luminescence in certain electroluminescent materials. In contrast, only a small percentage of excitons in fluorescent devices, which are singlet-based, result in fluorescent luminescence.

### II.C. Background of materials

### II.C.1. Basic heterostructures

Because one typically has at least one electron transporting layer and at least one hole transporting layer, one has layers of different materials, forming a heterostructure. The materials that produce the electroluminescent emission may be the same materials that function either as the electron transporting layer or as the hole transporting layer. Such devices in which the electron transporting layer or the hole transporting layer also functions as the emissive layer are referred to as having a single heterostructure. Alternatively, the electroluminescent material may be present in a separate emissive layer between the hole transporting layer and the electron transporting layer in what is referred to as a double heterostructure.

That is, in addition to emissive materials that are present as the predominant component in the charge carrier layer, that is, either in the hole transporting layer or in the electron transporting layer, and that function both as the charge carrier material as well as the emissive material, the emissive material may be present in relatively low concentrations as a dopant in the charge carrier layer. Whenever a dopant is present, the predominant material in the charge carrier layer may be referred to as a host compound or as a receiving compound. Materials that are present as host and dopant are selected so as to have a high level of energy transfer from the host to the dopant material. In addition, these materials need to be capable of producing acceptable electrical properties for the OLED. Furthermore, such host and dopant materials are preferably capable of being incorporated into the OLED using materials that can be readily incorporated into the OLED by using convenient fabrication techniques, in particular, by using vacuum-deposition techniques.

### II.C.2. Exciton blocking layer

The exciton blocking layer used in the devices of the present invention (and previously disclosed in WO0016593) substantially blocks the diffusion of excitons, thus substantially keeping the excitons within the emission layer to enhance device efficiency. The material of blocking layer of the present invention is characterized by an energy difference ("band gap") between its lowest unoccupied molecular orbital (LUMO) and its highest occupied molecular orbital (HOMO) In accordance with the present invention, this band gap substantially prevents the diffusion of excitons through the blocking layer, yet has only a minimal effect on the turn-on voltage of a completed electroluminescent device. The band gap is thus preferably greater than the energy level of excitons produced in an emission layer, such that such excitons are not able to exist in the blocking layer. Specifically, the band gap of the blocking layer is at least as great as the difference in energy between the triplet state and the ground state of the host.

### II.D. Color

As to colors, it is desirable for OLEDs to be fabricated using materials that provide electroluminescent emission in a relatively narrow band centered near selected spectral regions, which correspond to one of the three primary colors, red, green and blue so that they may be used as a colored layer in an OLED or SOLED. It is also desirable that such compounds be capable of being readily deposited as a thin layer using vacuum deposition techniques so that they may be readily incorporated into an OLED that is prepared entirely from vacuum-deposited organic materials.

U.S. Patent No. 6,048,630 is directed to OLEDs containing emitting compounds that produce a saturated red emission.

### III. SUMMARY OF THE INVENTION

The present invention is set out in the appended claims. Described are organic light emitting devices wherein the emissive layer comprises an emissive molecule, optionally with a host material (wherein the emissive molecule present as a dopant in said host material) which molecule is adapted to luminesce when a voltage is applied across the heterostructure, wherein the emissive molecule is selected from the group of phosphorescent organometallic complexes. The emissive molecule may be further selected from the group of phosphorescent organometallic iridium or osmium complexes and may be still further selected from the group of phosphorescent cyclometallated iridium or osmium complexes. A specific example of the emissive molecule is fac tris(2-phenylpyridine) iridium, denoted (Ir(ppy)₃) of formula 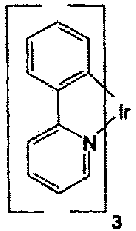 [In this, and later figures herein, we depict the dative bond from nitrogen to metal (here, Ir) as a straight line.]

The general arrangement of the layers is hole transporting layer, emissive layer, and electron transporting layer. For a hole conducting emissive layer, one may have an exciton blocking layer between the emissive layer and the electron transporting layer. For an electron conducting emissive layer, one may have an exciton blocking layer between the emissive layer and the hole transporting layer. The emissive layer may be equal to the hole transporting layer (in which case the exciton blocking layer is near or at the anode) or to the electron transporting layer (in which case the exciton blocking layer is near or at the cathode).

The emissive layer may be formed with a host material in which the emissive molecule resides as a guest or the emissive layer may be formed of the emissive molecule itself. In the former case, the host material may be a hole-transporting matrix selected from the group of substituted tri-aryl amines. An example of a host material is 4,4'-N,N'-dicarbazole-biphenyl (CBP), which has the formula 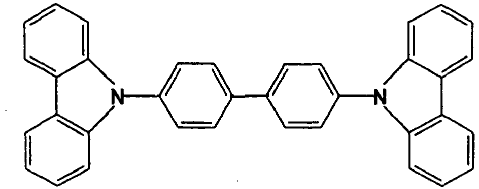 The emissive layer may also contain a polarization molecule, present as a dopant in said host material and having a dipole moment, that affects the wavelength of light emitted when said emissive dopant molecule luminesces.

A layer formed of an electron transporting material is used to transport electrons into the emissive layer comprising the emissive molecule and the (optional) host material. The electron transport material may be an electron-transporting matrix selected from the group of metal quinoxolates, oxadiazoles and triazoles. An example of an electron transport material is tris-(8-hydroxyquinoline) aluminum (Alq₃).

A layer formed of a hole transporting material is used to transport holes into the emissive layer comprising the emissive molecule and the (optional) host material. An example of a hole transporting material is 4,4'-bis[N-(1-naphthyl)-N-phenyl-amino] biphenyl ["α-NPD"].

The use of an exciton blocking layer ("barrier layer") to confine excitons within the luminescent layer ("luminescent zone") is greatly preferred. For a hole-transporting host, the blocking layer may be placed between the luminescent layer and the electron transport layer. An example of a material for such a barrier layer is 2,9-dimethyl-4,7-diphenyl-1,10-phenanthroline (also called bathocuproine or BCP), which has the formula

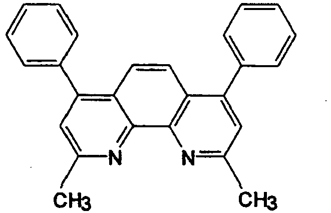

For a situation with a blocking layer between a hole-conducting host and the electron transporting layer (as is the case in Example 1, below), one seeks the following characteristics, which are listed in order of relative importance.
1. The difference in energy between the LUMO and HOMO of the blocking layer is greater than the difference in energy between the triplet and ground state singlet of the host material.
2. Triplets in the host material are not quenched by the blocking layer.
3. The ionization potential (IP) of the blocking layer is greater than the ionization potential of the host. (Meaning that holes are held in the host.)
4. The energy level of the LUMO of the blocking layer and the energy level of the LUMO of the host are sufficiently close in energy such that there is less than 50% change in the overall conductivity of the device.
5. The blocking layer is as thin as possible subject to having a thickness of the layer that is sufficient to effectively block the transport of excitons from the emissive layer into the adjacent layer.
[For a situation in which the emissive ("emitting") molecule is used without a hole transporting host, the above rules for selection of the blocking layer are modified by replacement of the word "host" by "emitting molecule."]

For the complementary situation with a blocking layer between a electron-conducting host and the hole-transporting layer one seeks characteristics (listed in order of importance):
1. The difference in energy between the LUMO and HOMO of the blocking layer is greater than the difference in energy between the triplet and ground state singlet of the host material.
2. Triplets in the host material are not quenched by the blocking layer.
3. The energy of the LUMO of the blocking layer is greater than the energy of the LUMO of the (electron-transporting) host. (Meaning that electrons are held in the host.)
4. The ionization potential of the blocking layer and the ionization potential of the host are such that holes are readily injected from the blocker into the host and there is less than a 50% change in the overall conductivity of the device.
5. The blocking layer is as thin as possible subject to having a thickness of the layer that is sufficient to effectively block the transport of excitons from the emissive layer into the adjacent layer.
[For a situation in which the emissive ("emitting") molecule is used without an electron transporting host, the above rules for selection of the blocking layer are modified by replacement of the word "host" by "emitting molecule."]

### IV. BRIEF DESCRIPTION OF THE DRAWINGS

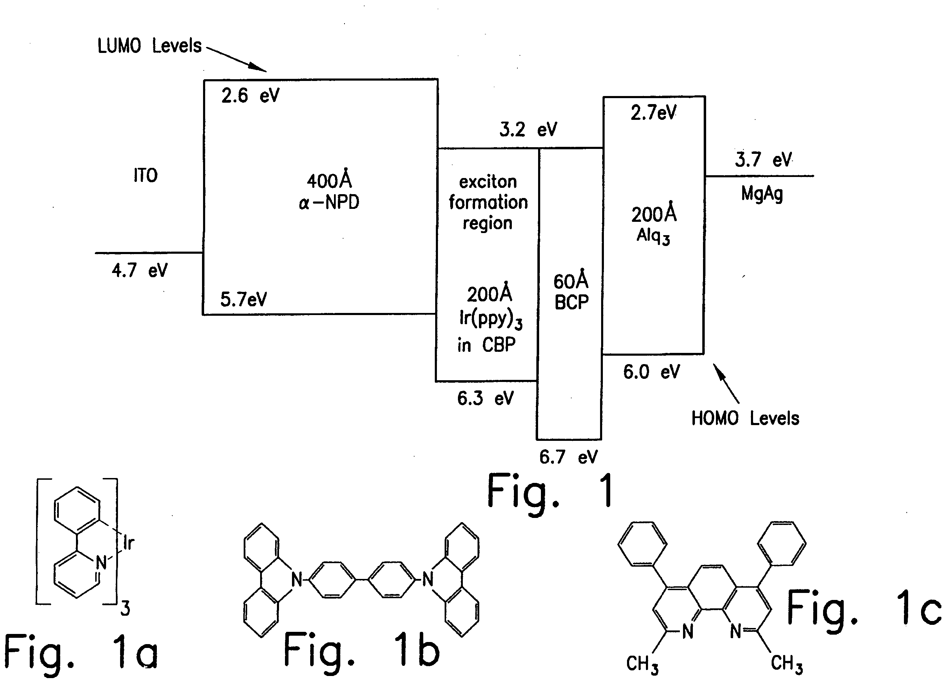

Figure 1. Proposed energy level structure of the electrophosphorescent device of Example 1. The highest occupied molecular orbital (HOMO) energy and the lowest unoccupied molecular orbital (LUMO) energy are shown (see I.G. Hill and A. Kahn, J. Appl. Physics (1999)). Note that the HOMO and LUMO levels for Ir(ppy)₃ are not known. The inset shows structural chemical formulae for
   (a) Ir(ppy)₃ (b) CBP and (c) BCP.

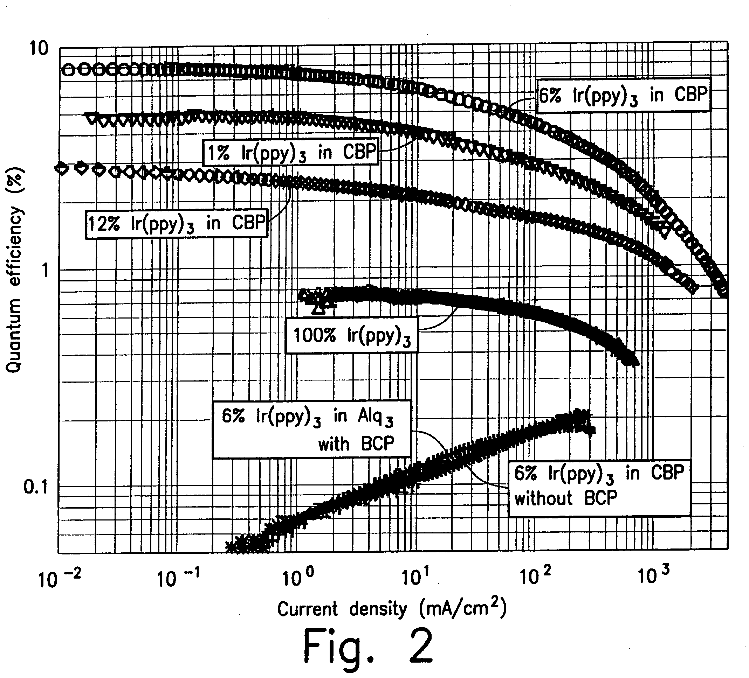

Figure 2. The external quantum efficiency of OLEDs using Ir(ppy)₃ : CBP luminescent layers. Peak efficiencies are observed for a mass ratio of 6% Ir(ppy)₃ to CBP. The 100% Ir(ppy)₃ device has a slightly different structure than shown in Fig. 1. In it, the Ir(ppy)₃ layer is 300 Å thick and there is no BCP blocking layer. The efficiency of a 6% Ir(ppy)₃ : CBP device grown without a BCP layer is also shown.

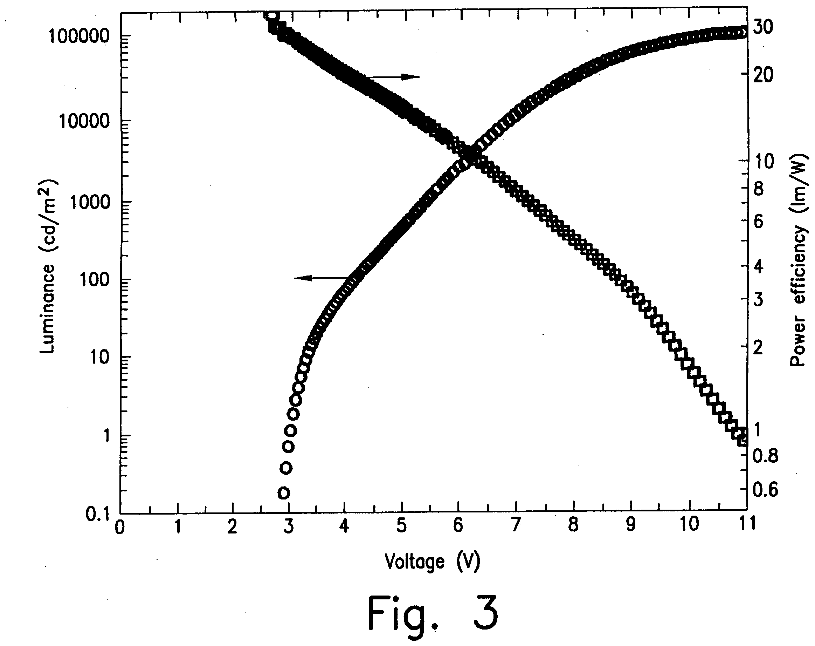

Figure 3. The power efficiency and luminance of the 6% Ir(ppy)₃ : CBP device. At 100 cd/m², the device requires 4.3 V and its power efficiency is 19 lm/W.

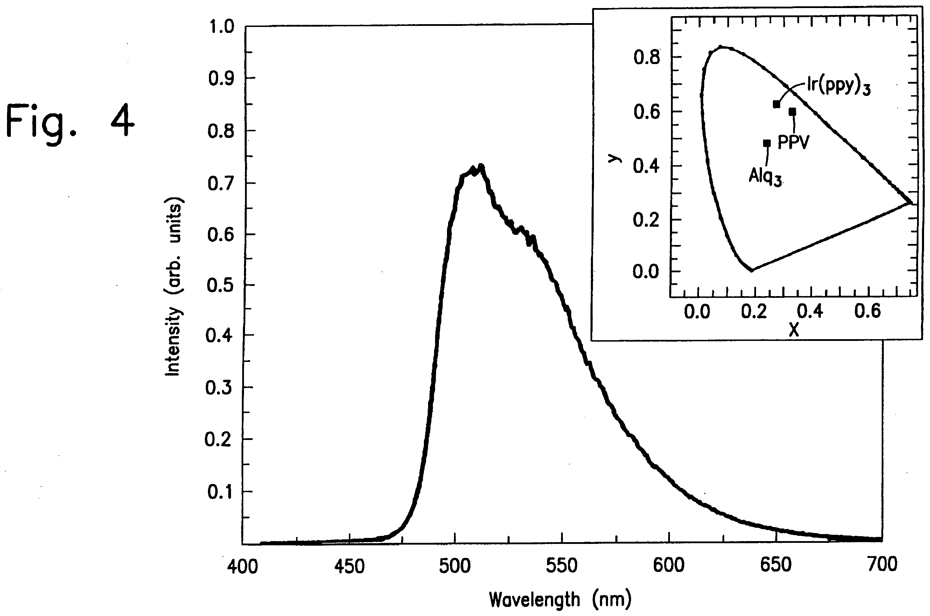

Figure 4. The electroluminescent spectrum of 6% Ir(ppy)₃ : CBP. Inset: The Commission Internationale de L'Eclairage (CIE) chromaticity coordinates of Ir(ppy)₃ in CBP are shown relative to fluorescent green emitters Alq₃ and poly(p-phenylenevinylene) (PPV).

### V. DETAILED DESCRIPTION OF THE INVENTION

The present invention is directed to the use as defined in claim 1. Described are emissive molecules, which luminesce when a voltage is applied across a heterostructure of an organic light-emitting device and which molecules are selected from the group of phosphorescent organometallic complexes, and to structures, and correlative molecules of the structures, that optimize the emission of the light-emitting device. The term "organometallic" is as generally understood by one of ordinary skill, as given, for example, in "Inorganic Chemistry" (2nd edition) by Gary L. Miessler and Donald A. Tarr, Prentice-Hall (1998). The invention is further directed to emissive molecules within the emissive layer of an organic light-emitting device which molecules are comprised of phosphorescent cyclometallated iridium complexes. On electroluminescence, molecules in this class may produce emission which appears red, blue, or green. Discussions of the appearance of color, including descriptions of CIE charts, may be found in Color Chemistry, VCH Publishers, 1991 and H. J. A. Dartnall, J. K. Bowmaker, and J. D. Mollon, Proc. Roy. Soc. B (London), 1983, 220, 115-130.

The present invention will now be described in detail for specific preferred embodiments of the invention, it being understood that these embodiments are intended only as illustrative examples and the invention is not to be limited thereto.

### Examples

### Example 1

In this example, we describe OLEDs employing the green, electrophosphorescent material *fac* tris(2-phenylpyridine) iridium (Ir(ppy)₃). This compound has the following formulaic representation: 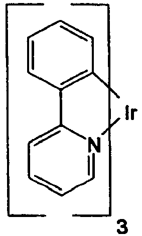 The coincidence of a short triplet lifetime and reasonable photoluminescent efficiency allows Ir(ppy)₃-based OLEDs to achieve peak quantum and power efficiencies of 8.0% (28 cd/A) and ∼30 lm/W respectively. At an applied bias of 4.3V, the luminance reaches 100cd/m² and the quantum and power efficiencies are 7.5% (26 cd/A) and 19 lm/W, respectively.

Organic layers were deposited by high vacuum (10⁻⁶ Torr) thermal evaporation onto a cleaned glass substrate precoated with transparent, conductive indium tin oxide. A 400 Å thick layer of 4,4'-bis(N-(1-naphthyl)-N-phenyl-amino] biphenyl ((α-NPD) is used to transport holes to the luminescent layer consisting of Ir(ppy)₃ in CBP. A 200Å thick layer of the electron transport material tris-(8-hydroxyquinoline) aluminum (Alq₃) is used to transport electrons into the Ir(ppy)₃:CBP layer, and to reduce Ir(ppy)₃ luminescence absorption at the cathode. A shadow mask with 1 mm diameter openings was used to define the cathode consisting of a 1000 Å thick layer of 25:1 Mg:Ag, with a 500Å thick Ag cap. As previously (O'Brien, et al., App. Phys. Lett. 1999, 74,442-444), we found that a thin (60 Å) barrier layer of 2,9-dimethyl-4,7-diphenyl-1,10-phenanthroline (bathocuproine, or BCP) inserted between the C3P and the Alq₃ was necessary to confine excitons within the luminescent zone and hence maintain high efficiencies. In O'Brien et al., Appl. Phys. Lett. 1999, 74, 442-444, it was argued that this layer prevents triplets from diffusing outside of the doped region. It was also suggested that CBP may readily transport holes and that BCP may be required to force exciton formation within the luminescent layer. In either case, the use of BCP clearly serves to trap excitons within the luminescent region. The molecular structural formulae of some of the materials used in the OLEDs, along with a proposed energy level diagram, is shown in Fig. 1.

Figure 2 shows the external quantum efficiencies of several Ir(ppy)₃-based OLEDs. The doped structures exhibit a slow decrease in quantum efficiency with increasing current. Similar to the results for the Alq₃:PtOEP system the doped devices achieve a maximum efficiency (∼8%) for mass ratios of Ir(ppy)₃:CBP of approximately 6-8%. Thus, the energy transfer pathway in Ir(ppy)₃:CBP is likely to be similar to that in PtOEP:Alq₃ (Baldo, et al., Nature, 1998, 395,151; O'Brien, 1999, op. cit.) i.e. via short range Dexter transfer of triplets from the host. At low Ir(ppy)₃ concentrations, the lumophores often lie beyond the Dexter transfer radius of an excited Alq₃ molecule, while at high concentrations, aggregate quenching is increased. Note that dipole-dipole (Förster) transfer is forbidden for triplet transfer, and in the PtOEP:Alq₃ system direct charge trapping was not found to be significant.

### Example 2

In addition to the doped device, we fabricated a heterostructure where the luminescent region was a homogeneous firm of Ir(ppy)₃. The reduction in efficiency (to ∼0.8%) of neat Ir(ppy)₃ is reflected in the transient decay, which has a lifetime of only ∼100ns, and deviates significantly from mono-exponential behavior. A 6% Ir(ppy)₃:CBP device without a BCP barrier layer is also shown together with a 6% Ir(ppy)₃:Alq₃ device with a BCP barrier layer. Here, very low quantum efficiencies are observed to increase with current. This behavior suggests a saturation of nonradiative sites as excitons migrate into the Alq₃, either in the luminescent region or adjacent to the cathode.

### Example 3

In Fig. 3 we plot luminance and power efficiency as a function of voltage for the device of Example 1. The peak power efficiency is ∼30 lm/W with a quantum efficiency of 8%, (28 cd/A). At 100cd/m², a power efficiency of 19 lm/W with a quantum efficiency of 7.5% (26 cd/A) is obtained at a voltage of 4.3V. The transient response of Ir(ppy)₃ in CBP is a mono-exponential phosphorescent decay of ∼500ns, compared with a measured lifetime (e.g., King, et al., J. Am. Chem. Soc., 1985, 107, 1431-1432) of 2µs in degassed toluene at room temperature. These lifetimes are short and indicative of strong spin-orbit coupling, and together with the absence of Ir(ppy)₃ fluorescence in the transient response, we expect that Ir(ppy)₃ possesses strong intersystem crossing from the singlet to the triplet state. Thus all emission originates from the long lived triplet state. Unfortunately, slow triplet relaxation can form a bottleneck in electrophosphorescence and one principal advantage of Ir(ppy)₃ is that it possesses a short triplet lifetime. The phosphorescent bottleneck is thereby substantially loosened. This results in only a gradual decrease in efficiency with increasing current, leading to a maximum luminance of ∼100,000 cd/m².

### Example 4

In Fig. 4, the emission spectrum and Commission Internationale de L'Eclairage (CIE) coordinates of Ir(ppy)₃ are shown for the highest efficiency device. The peak wavelength is λ=510nm and the full width at half maximum is 70nm. The spectrum and CIE coordinates (x=0.27,y=0.63) are independent of current. Even at very high current densities (∼100 mA/cm²) blue emission from CBP is negligible - an indication of complete energy transfer.

Other techniques known to one of ordinary skill may be used in conjunction with the present invention. For example, the use of LiF cathodes (Hung, et al., Appl. Phys. Lett., 1997, 70, 152-154), shaped substrates (G. Gu, et al., Optics Letters, 1997, 22, 396-398), and novel hole transport materials that result in a reduction in operating voltage or increased quantum efficiency (B. Kippelen, et al., MRS (San Francisco, Spring, 1999) are also applicable to this work. These methods have yielded power efficiencies of -20 lm/W in fluorescent small molecule devices (Kippelen, Id.). The quantum efficiency in these devices (Kido and Iizumi, App. Phys. Lett., 1998, 73, 2721) at 100cd/m² is typically ≤4.6% (lower than that of the present invention), and hence green-emitting electrophosphorescent devices with power efficiencies of, >40 lm/W can be expected. Purely organic materials (Hoshino and Suzuki, Appl. Phys. Lett., 1996, 69, 224-226) may sometimes possess insufficient spin orbit coupling to show strong phosphorescence at room temperature. While one should not rule out the potential of purely organic phosphors, the preferred compounds may be transition metal complexes with aromatic ligands. The transition metal mixes singlet and triplet states, thereby enhancing intersystem crossing and reducing the lifetime of the triplet excited state.

The present invention is not limited to the emissive molecule of the examples. One of ordinary skill may modify the organic component of the Ir(ppy)3 (directly below) to obtain desirable properties. 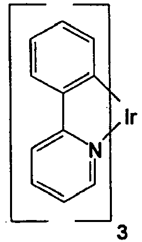 One may have alkyl substituents or alteration of the atoms of the aromatic structure. 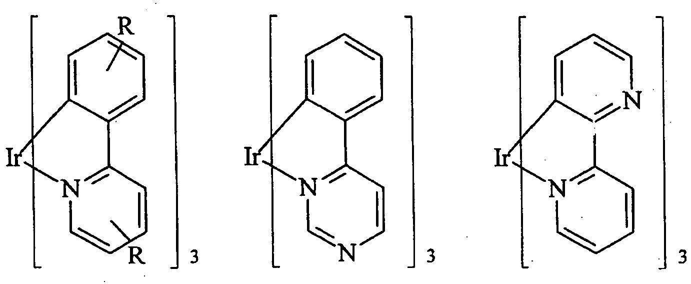 These molecules, related to Ir(ppy)₃, can be formed from commercially available ligands. The R groups can be alkyl or aryl and are preferably in the 3, 4. 7 and/or 8 positions on the ligand (for steric reasons). The compounds should give different color emission and may have different carrier transport rates. Thus, the modifications to the basic Ir(ppy)₃ structure in the three molecules can alter emissive properties in desirable ways.
Other possible emitters are illustrated below. 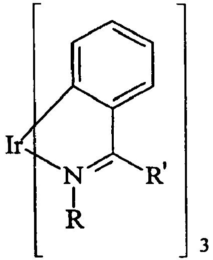 This molecule is expected to have a blue-shifted emission compared to Ir(ppy)₃. R and R' can independently be alkyl or aryl.

The molecule of the hole-transporting layer of Example 1 is depicted below. 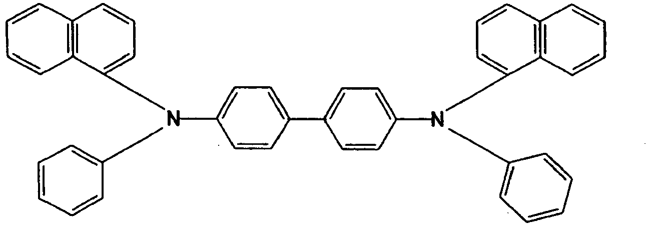 The invention will work with other hole-transporting molecules known by one of ordinary skill to work in hole transporting layers of OLEDs.

The molecule used as the host in the emissive layer of Example 1 is depicted below. 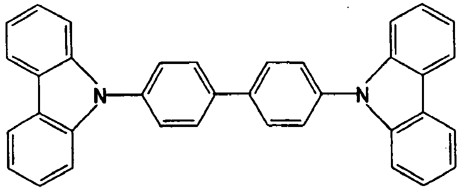 The invention will work with other molecules known by one of ordinary skill to work as hosts of emissive layers of OLEDs. For example, the host material could be a hole-transporting matrix and could be selected from the group consisting of substituted tri-aryl amines and polyvinylcarbazoles.

The molecule used as the exciton blocking layer of Example 1 is depicted below. The invention will work with other molecules used for the exciton blocking layer, provided they meet the requirements listed in the summary of the invention. 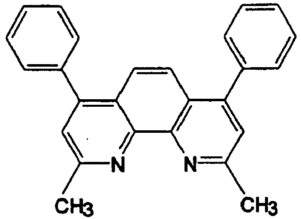 Molecules which are suitable as components for an exciton blocking layer are not necessarily the same as molecules which are suitable for a hole blocking layer. For example, the ability of a molecule to function as a hole blocker depends on the applied voltage, the higher the applied voltage, the less the hole blocking ability. The ability to block excitons is roughly independent of the applied voltage.

The OLED of the present invention may be used in substantially any type of device which is comprised of an OLED, for example, in OLEDs that are incorporated into a larger display, a vehicle, a computer, a television, a printer, a large area wall, theater or stadium screen, a billboard or a sign.

## Claims

1. Use of a phosphorescent organometallic cyclometallated iridium compound as emissive molecule within the emissive layer of an organic light emitting device comprising a heterostructure, wherein the emissive molecule produces luminescent emission when a voltage is applied across the heterostructure,
wherein the phosphorescent organometallic cyclometallated iridium compound is a substituted compound, denoted by the formula 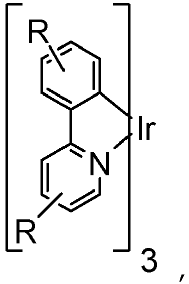
wherein the R groups are selected from alkyl or aryl; or
wherein the phosphorescent organometallic cyclometallated iridium compound is denoted by the formula

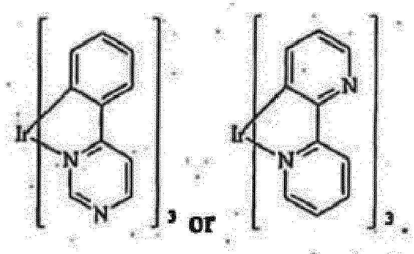

2. The use of claim 1, wherein R is an alkyl group.

3. The use of claim 1, wherein R is an aryl group.

4. The use of any of claims 1 to 3, wherein the emissive layer further comprises a host material, and the phosphorescent organometallic cyclometallated iridium compound is present as a dopant in the host material.

## Patentansprüche

1. Verwendung einer phosphoreszenten, organometallischen, cyclometallierten Iridiumverbindung als emittierendes Molekül in der emittierenden Schicht einer organischen Licht emittierenden Vorrichtung, umfassend eine Heterostruktur, wobei das emittierende Molekül eine lumineszente Emission erzeugt, wenn eine Spannung durch die Heterostruktur angelegt wird
wobei die phosphoreszente, organometallische, cyclometallierte Iridiumverbindung eine substituierte Verbindung ist, dargestellt durch die Formel 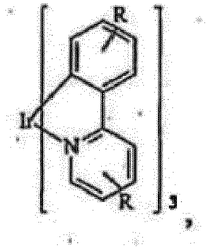 wobei die R-Gruppen ausgewählt sind aus Alkyl oder Aryl; oder
wobei die phosphoreszente, organometallische, cyclometallierte Iridiumverbindung dargestellt wird durch die Formel

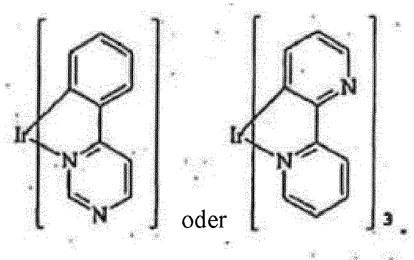

2. Verwendung gemäß Anspruch 1, wobei R eine Alkylgruppe ist.

3. Verwendung gemäß Anspruch 1, wobei R eine Arylgruppe ist.

4. Verwendung gemäß irgendeinem der Ansprüche 1 bis 3, wobei die emittierende Schicht des Weiteren ein Wirtsmaterial umfasst und die phosphoreszente, organometallische, cyclometallierte Iidiumverbindung als ein Dotierstoff in dem Wirtsmaterial vorliegt.

## Revendications

1. Utilisation d'un composé d'iridium cyclométallisé organométallique phosphorescent en tant que molécule émissive dans la couche émissive d'un dispositif électroluminescent organique comprenant une hétérostructure, dans laquelle la molécule émissive produit une émission luminescente lorsqe l'on applique une tension a l'hétérostructure,
dans lequel le composé organométallique phosphorescent d'iridium cyclométallisé est un composé substitué, représenté par la formule 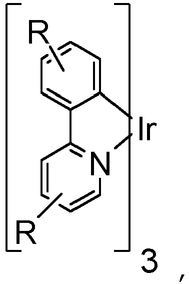 dans laquelle les groupes R sont choisis parmi les groupes alkyle ou aryle ; ou
dans lequel le composé organométallique phosphorescent d'iridium cyclométallisé est représenté par la formule

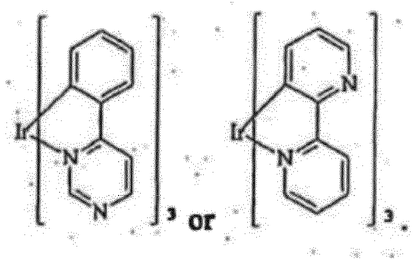

2. L'utilisation de la revendication 1, dans laquelle R est un groupe alkyle.

3. L'utilisation de la revendication 1, dans laquelle R est un groupe aryle.

4. L'utilisation de l'une quelconque des revendications 1 à 3, dans laquelle la couche émissive comprend en outre un matériau hôte, et le composé organométallique phosphorescent d'iridium cyclométallisé est présent en tant que dopant dans le matériau hôte.
